# EUROPEAN PATENT APPLICATION

(11) **EP 0 917 208 A1**
(43) Date of publication of application: **19.05.1999**
(21) Application number: 97203499.5
(22) Date of filing: 11.11.1997
(51) Int. Cl.: H01L 31/0384, H01L 51/20, H01L 51/30, H01L 33/00

(54) **Polymer-nanocrystal photo device and method for making the same**

(71) Applicant: Universiteit van Utrecht, 3584 CS Utrecht (NL)
(72) Inventor: Schropp, Rudolf Emmanuel Isidore, 3972 GE Driebergen (NL); Salafsky, Joshua Samuel, Rockford, IL 61114 (US)
(74) Representative: Land, Addick Adrianus Gosling

(57) **Abstract**

Especially for reducing costs for photovoltaic cells, research is done all around the world for finding a solid state composition of creating an interpenetrating solid-state conducting material in a nanoporous network. Such device could also be used for LED (light emitting diodes), photo sensors, optical switches and even optical networks.

This invention relates to a photo device comprising a layer of nanometer sized particles and a conducting polymer in solid state, wherein
the nanometer sized particles are chosen from the group of TiO₂, ZnO, CdSe, CdS, ZrO₂, SnO₂ and
wherein the conducting polymer comprises PPV (polyparaphenylenevinylene) or a derivative thereof.

## Description

Especially for reducing costs for photovoltaic cells, research is done all around the world for finding a solid state composition of creating a interpenetrating solid-state conducting material in a nanoporous network. Such device could also be used for LED (light emitting diodes), photo sensors, optical switches and even optical networks.

This invention intends to offer a solution to the problem of creating an interpenetrating solid-state conducting material in a nanoporous network, for the purpose of creating stable, all-solid state photovoltaic cells. Thus, the instability problems associated with liquid-based electrolytes in nanoporous networks (1) can be eliminated. Prior methods have been published on the insertion of a polymer electrolyte into a preformed nanocrystalline TiO₂ (titanium dioxide) network (2) but this methods have the disadvantage of being based on an ionic conductor thus limiting the device performance, rather than on an electronic conductor such as the one we describe here. Another prior method using conducting polymers (PPV and derivatives) replaces the inorganic nanocrystalline network with C₆₀ and derivatives which act as electron-acceptors (3). However, in this method, the electron transport is restricted. Further, C₆₀ is not a material which can be produced abundantly, and is thus expensive; it is also much less stable than inorganic materials. The present invention offers the stability, electron tranporting properties, and low cost of a TiO₂ interconnected network in combination with the hole-transporting, light-absorbing, stable properties of PPV (poly-paraphenylenevinylene). A further aspect of this invention is the ease of manufacturing, namely in a single thermal treatment of the inorganic and organic materials together.

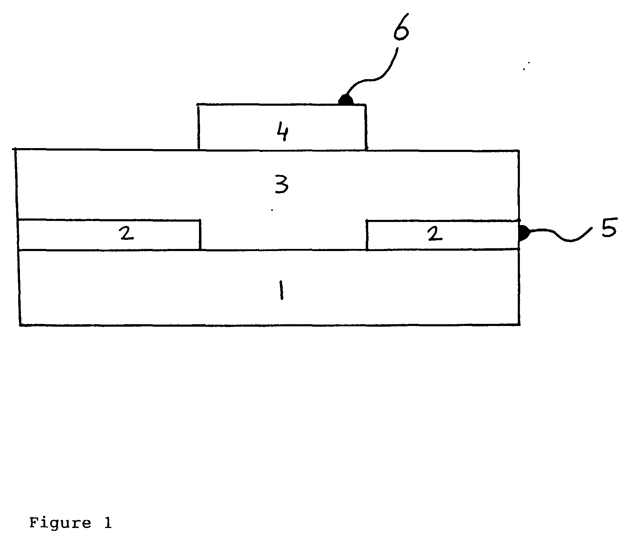

An example of this method according to this invention uses a conducting polymer, p-PPV (precursor PPV) and a nanocrystalline material, TiO₂. A schematic cross-section of the cell is show, in Fig. 1. The polymer p-PPV was made by chemical synthesis (4). TiO₂ nanocrystals were obtained from Degussa AG corporation, Germany. An approximately 0.7% methanol solution of the p-PPV was combined with a colloid of TiO₂ made according to reference 5 to give a mixture of approximately 1:1 p-PPV and TiO₂,by weight. This mixture was spin-coated on a glass substrate 1 with a transparent conducting coating 2, in this example SnO2:F, to give a thin film 3. The film was heated to 320 °C for ten hours in vacuum and an aluminum contact 4 evaporated in such a way that there is no overlap with the transparent (with methods commonly known in the field), conducting coating on the glass on top of the film to complete the cell.

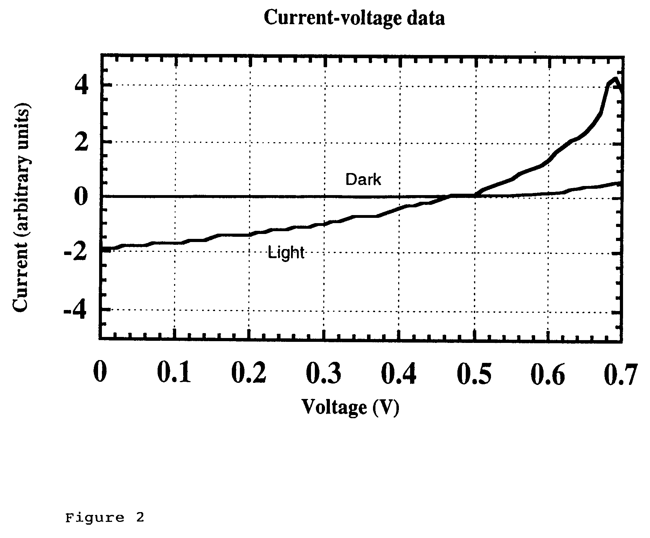

Current-voltage (IV) curves of the cells in the dark and in white light were measured at terminals 5 and 6 (Fig. 1) and a plot of this data is shown in Fig. 2 which demonstrates that the cells produce electric power under illumination.

The main novelty and crucial distinction of this method over other methods is the thermal treatment step, which is necessary for both conversion of the p-PPV to its final conducting form, PPV; and, to produce electrical contact between the TiO₂ particles to produce electron-carrying paths through the film. Our method is the first one to make operational photovoltaic cells of a conducting polymer, such as PPV, and a sintered electrically interconnected network of nanocrystalline particles, such as TiO₂. PPV has been shown to be a good hole-conducting material (4) and TiO₂ an excellent electron transporter (1), so their combination together, prepared in a single thermal treatment step, also represents a significant advance.

The method is general for a range of temperatures, other polymers, or nanocrystals.

## Claims

1. A photo device comprising a layer of nanometer sized particles and a conducting polymer in solid state.

2. A photo device according to claim 1, wherein the nanometer sized particles are chosen from the group of TiO₂, ZnO, CdSe, CdS, ZrO₂, SnO₂.

3. A photo device according to claim 1 or 2, wherein the conducting polymer comprises PPV (polyparaphenylenevinylene) or a derivative thereof.

4. A photo device according to claim 1, 2 or 3, wherein the layer is a thin film of a photovoltaic cell.

5. A method for producing a photo device, according to claim 1, wherein the layer is heated to a predetermined temperature during a predetermined time.

6. A method according to claim 5, wherein the heating takes place at substantial underpressure or vacuum.
